Europäisches Patentamt

European Patent Office

Office européen des brevets

(19)

(11) **EP 0 769 224 B1**

(12) **EUROPÄISCHE PATENTSCHRIFT**

(45) Veröffentlichungstag und Bekanntmachung des Hinweises auf die Patenterteilung:
**09.09.1998 Patentblatt 1998/37**

(21) Anmeldenummer: **95921722.5**

(22) Anmeldetag: **22.06.1995**

(51) Int Cl.$^6$: **H03M 1/54**

(86) Internationale Anmeldenummer:
**PCT/DE95/00813**

(87) Internationale Veröffentlichungsnummer:
**WO 96/02090 (25.01.1996 Gazette 1996/05)**

(54) **VERFAHREN ZUM ANALOG-/DIGITAL-WANDELN EINES ELEKTRISCHEN SIGNALS UND VORRICHTUNG ZUR DURCHFÜHRUNG DES VERFAHRENS**

PROCESS FOR THE ANALOG/DIGITAL CONVERSION OF AN ELECTRIC SIGNAL AND DEVICE FOR IMPLEMENTING IT

PROCEDE DE CONVERSION ANALOGIQUE/NUMERIQUE D'UN SIGNAL ELECTRIQUE ET DISPOSITIF DE MISE EN UVRE DUDIT PROCEDE

(84) Benannte Vertragsstaaten:
**DE ES FR GB IT**

(30) Priorität: **07.07.1994 DE 4423955**

(43) Veröffentlichungstag der Anmeldung:
**23.04.1997 Patentblatt 1997/17**

(73) Patentinhaber: **ROBERT BOSCH GMBH**
**70442 Stuttgart (DE)**

(72) Erfinder: **MOHR, Thomas**
**D-77815 Buehl (DE)**

(56) Entgegenhaltungen:
EP-A- 0 252 852          DE-A- 3 041 954
US-A- 3 633 201          US-A- 4 584 566

EP 0 769 224 B1

**Beschreibung**

Stand der Technik

Die Erfindung geht aus von einem Verfahren zum Analog/Digital-Wandeln eines elektrischen Signals und einer Vorrichtung zur Durchführung des Verfahrens nach der Gattung der unabhängigen Ansprüche. Aus dem Fachbuch von U. Tietze u. Ch. Schenk, "Halbleiter-Schaltungstechnik", 2. Auflage 1971, S. 536-537 sind ein Verfahren und eine Vorrichtung zum Analog-/Digital-Wandeln eines elektrischen Signals bekannt, die auf einem Doppelintegrationsverfahren beruhen. In einem ersten Verfahrensschritt wird ein Integrator auf den Ausgangswert Null gestellt. In einem zweiten Verfahrensschritt integriert der Integrator die zu wandelnde Eingangsspannung für eine vorgegebene Zeit auf. Nach Ablauf der vorgegebenen Zeit wird in einem dritten Verfahrensschritt anstelle der zu wandelnden Spannung eine bekannte Referenzspannung an den Integrator gelegt, der eine Abintegration vornimmt, bis der Ausgangswert Null des Integrators wieder erreicht wird. Die für die Abintegration benötigte Zeit wird als Maß für die zu wandelnde Spannung gewertet. Die für das bekannte Doppelintegrationsverfahren benötigten Funktionen, beispielsweise Integrator, Komparator, Taktgenerator, Steuerlogik sowie Zähler sind heute vollständig in integrierten Schaltkreisen enthalten.

Aus dem Dokument US - A - 4 584 566 ist ein weiterer A/D-Wandler bekannt, bei dem in einem Integrationsglied ein Kondensator mittels eines eingeprägten Stromes bis zu einer oberen und unteren Scbwellspannung auf- und entladen wird. Die zu wandelnde Spannung wird als Strom dem Umladevorgang hinzuaddiert und verändert das Tastverhältnis, so daß aus dem ursprünglich dreieckförmigen Kurvenverlauf ein sägezahnförmiger Verlauf entsteht. Das Tastverhältnis wird als Maß für die zu messende Spannung ausgewertet.

Der Erfindung liegt die Aufgabe zugrunde, ein Verfahren zum Analog-/Digital-Wandeln eines elektrischen Signals sowie eine Vorrichtung zum Durchführen des Verfahrens anzugeben, die besonders einfach, insbesondere in Verbindung mit einem Mikroprozessor realisierbar sind.

Die Aufgabe wird durch die im unabhängigen Verfahrensanspruch und im nebengeordneten Vorrichtungsanspruch enthaltenen Merkmalen gelöst.

Vorteile der Erfindung

Das erfindungsgemäße Verfahren zum Analog-/Digital-Wandeln eines elektrischen Signals weist den Vorteil auf, daß eine relativ hohe Genauigkeit erreichbar ist, die lediglich von der Toleranz einer Widerstands-Kondensator-Kombination (RC-Glied) abhängig ist. Ein wesentlicher Vorteil ist die besonders kostengünstige Realisierung, die mit wenigen Bauteilen erfolgen kann. Insbesondere geeignet zur Realisierung ist ein Mikroprozessor, der durch das erfindungsgemäße Verfahren keinen Analog-/Digital-Wandler zu enthalten braucht.

In einem ersten Verfahrensschritt wird der Kondensator des RC-Glieds auf die zu wandelnde Spannung geladen. In einem zweiten Verfahrensschritt wird der Kondensator über ein strombegrenzendes Element mit einer Spannungsquelle verbunden, deren Spannung höher oder niedriger liegt als eine Vergleichsspannung. In einem dritten Verfahrensschritt wird die Zeit der Spannungsänderung am Kondensator bis zum Erreichen der Vergleichsspannung ermittelt. Die Zeit ist ein Maß für die zu wandelnde Spannung.

Vorteilhafte Weiterbildungen und Ausgestaltungen des erfindungsgemäßen Verfahrens zum Analog-/Digital-Wandeln eines elektrischen Signals ergeben sich aus abhängigen Ansprüchen.

Eine vorteilhafte Ausgestaltung sieht vor, daß die Vergleichsspannung mit einer Schaltschwelle eines Komparators realisiert wird. Unter einem Komparator wird im folgenden auch eine Eingangsschaltung eines logischen Bauelements, beispielsweise eines Mikroprozessors verstanden, das wenigstens eine definierte Schaltschwelle aufweist.

Eine vorteilhafte Weiterbildung dieser Maßnahme sieht vor, daß der Komparator eine Schalthysterese aufweist, wobei zwei unterschiedliche Schaltschwellen entstehen. Mit dieser Maßnahme ist es möglich, einen weiten zulässigen Bereich für die zu wandelnde Spannung vorzusehen.

Eine vorteilhafte Ausgestaltung sieht vor, daß die Auswahl zwischen der höheren oder der niedrigeren Spannung der Spannungsquelle in Abhängigkeit vom Komparatorausgangssignal vorgegeben wird. Die Steuerung in Abhängigkeit vom Komparatorausgangssignal stellt sicher, daß die Spannung am Kondensator, ausgehend von der zu wandelnden Spannung, stets die Vergleichsspannung erreichen kann.

Eine vorteilhafte andere Ausgestaltung sieht vor, daß die eine oder vorzugsweise zwei Schaltschwellen des Komparators adaptiv ermittelt werden. Mit diesem Lernvorgang ist eine hohe Kurzzeitstabilität und somit eine hohe Meßgenauigkeit unabhängig von der einen oder der beiden Schaltschwellen des Komparators erreichbar.

Die erfindungsgemäße Vorrichtung weist den Vorteil einer besonders kostengünstigen Realisierung auf. Der Kondensator ist über einen Widerstand als strombegrenzendes Element mit einem Schalter verbunden, der einen hochohmigen Schaltzustand aufweisen kann. Die Vergleichsspannung ist als Schwelle des Komparators realisiert.

Vorteilhafte Ausgestaltungen und Weiterbildungen der erfindungsgemäßen Vorrichtung zur Durchführung des Verfahrens zum Analog-/Digital-Wandeln eines elektrischen Signals ergeben sich aus abhängigen Vorrichtungsansprüchen.

Eine besonders vorteilhafte Ausgestaltung sieht vor, daß der Schalter, der Komparator sowie eine Zeitermittlung in einem Mikroprozessor enthalten sind. Wie bereits erwähnt, ist der Komparator eine im Mikroprozessor enthaltene Eingangsschaltung hinter einem Mikroprozessor-Input-Port, der vorzugsweise eine Hysterese aufweist. Solche Eingänge werden auch als Schmitt-Trigger-Eingänge bezeichnet. Als externe Bauelemente werden lediglich noch das RC-Glied sowie gegebenenfalls ein Eingangswiderstand benötigt.

Weitere vorteilhafte Ausgestaltungen und Weiterbildungen des erfindungsgemäßen Verfahrens zum Analog-/Digital-Wandeln eines elektrischen Signals sowie der erfindungsgemäßen Vorrichtung zur Durchführung des Verfahrens ergeben sich aus weiteren abhängigen Ansprüchen in Verbindung mit der folgenden Beschreibung.

Zeichnung

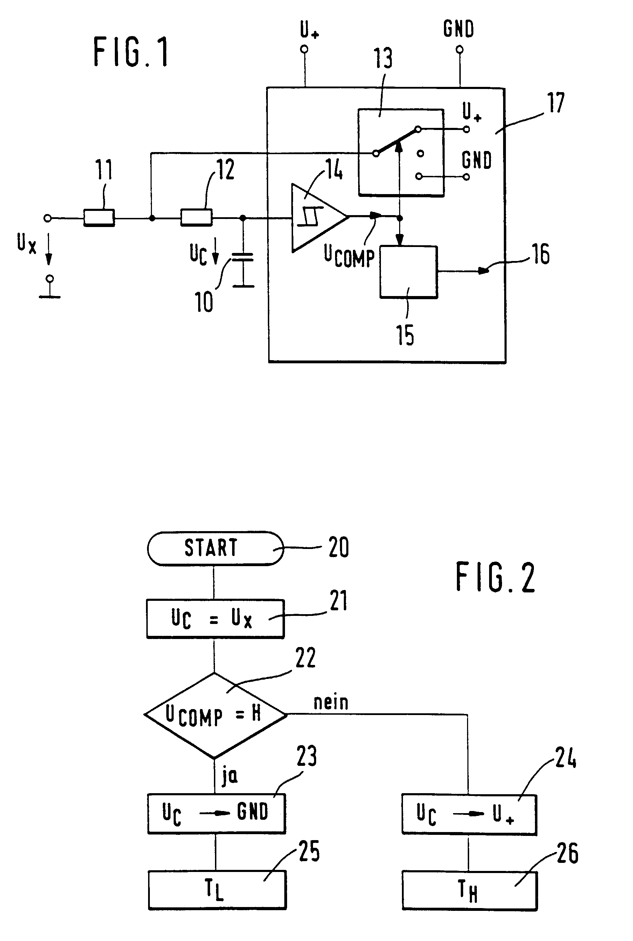

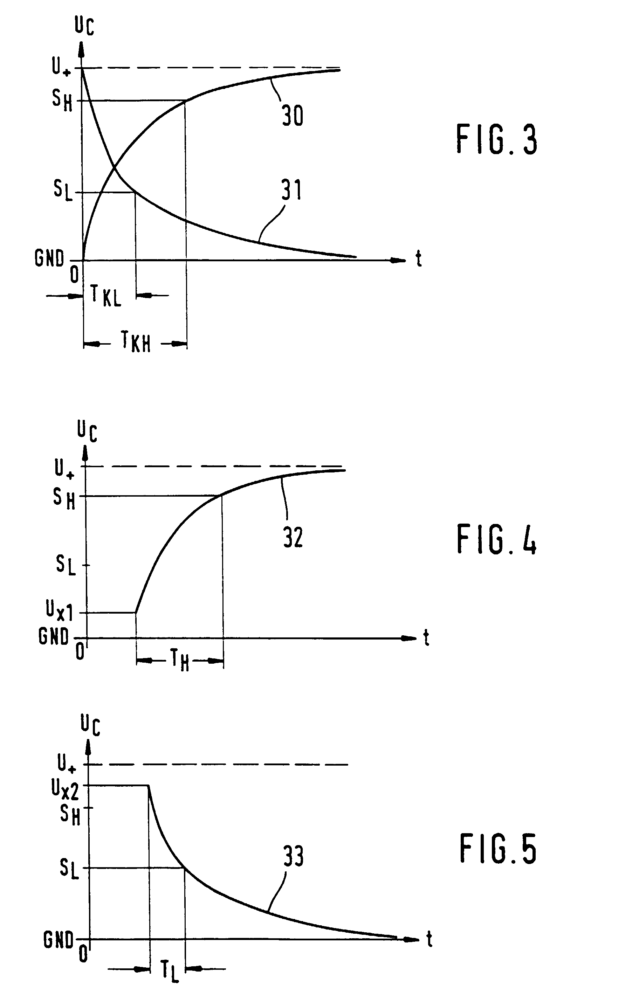

Figur 1 zeigt ein Blockschaltbild einer erfindungsgemäßen Vorrichtung zur Durchführung eines Verfahrens zum Analog/Digital-Wandeln eines elektrischen Signals, dessen Flußdiagramm in Figur 2 gezeigt ist, und die Figuren 3 bis 5 zeigen Spannungsverläufe an einem in Figur 1 enthaltenen Kondensator in Abhängigkeit von der Zeit.

Figur 1 zeigt einen Kondensator 10, der über einen Eingangswiderstand 11 und Integrationswiderstand 12 mit einer zu wandelnden Spannung $U_x$, über den Integrationswiderstand 12 mit einem Umschalter 13 sowie mit einem Komparator 14 jeweils verbunden ist. Am Kondensator 10 liegt die Kondensatorspannung $U_C$. Der Komparator 14 kann eine Schalthysterese aufweisen, die durch das im Komparator 14 eingetragene Zeichen symbolisiert ist.

Der Komparator 14 gibt ein Komparatorausgangssignal $U_{COMP}$ sowohl an den Umschalter 13 als auch eine Zeitermittlung 15 ab. Die Zeitermittlung 15 gibt ein Ergebnissignal 16 ab, das ein Maß für die zu wandelnde Spannung $U_x$ darstellt.

Der Umschalter 13 enthält drei Schaltpositionen. Eine erste Position verbindet den Integrationswiderstand 12 mit einer positiven Betriebsspannung $U_+$. Eine zweite Position des Umschalters 13 entspricht einem hochohmigen Zustand und eine dritte Schaltposition des Umschalters 13 verbindet den Integrationswiderstand 12 mit einer negativen Betriebsspannung GND.

Der Umschalter 13, der Komparator 14 sowie die Zeitermittlung 15 sind in einem Mikroprozessor 17 angeordnet, dem die positive Betriebsspannung $U_+$ sowie die negative Betriebsspannung GND zugeführt sind.

Das in Figur 2 gezeigte Flußdiagramm beginnt nach einem Start 20 mit einem ersten Verfahrensschritt 21, bei dem die Kondensatorspannung $U_C$ auf den Wert der zu wandelnden Spannung $U_x$ geladen wird. In Abhängigkeit von einer Abfrage 22, in der festgestellt wird, ob das Komparatorausgangssignal $U_{COMP}$ Highpegel (H-Pegel) aufweist, wird in einem zweiten Verfahrensschritt entweder zur ersten oder zur zweiten Anweisung 23, 24 gegangen. In der ersten Anweisung 23 wird der Kondensator 10 über ein strombegrenzendes Element mit der negativen Betriebsspannung GND und in der zweiten Anweisung 24 wird der Kondensator über ein strombegrenzendes Element mit in der positiven Betriebsspannung $U_+$ verbunden. Nach der ersten Anweisung 23 ist eine erste Zeitermittlung 25 vorgesehen, welche eine Abintegrationszeit $T_L$ ermittelt, innerhalb der die Kondensatorspannung $U_C$, ausgehend von der zu wandelnden Spannung $U_x$, eine Vergleichsspannung des Komparators 14 aufweist. Nach der zweiten Anweisung 24 ist eine zweite Zeitermittlung 26 vorgesehen, welche eine Aufintegrationszeit $T_H$ ermittelt, innerhalb der die Kondensatorspannung $U_C$, ausgehend von der zu wandelnden Spannung $U_x$, die Vergleichsspannung des Komparators 14 erreicht.

Figur 3 zeigt zwei Kondensatorspannungen $U_C$ in Abhänigkeit von der Zeit t, die bei einem Lernvorgang von Schaltschwellen des Komparators 14 auftreten. Ein erster Kurvenverlauf 30 beginnt bei der negativen Betriebsspannung GND und nähert sich durch Aufladen über den Integrationswiderstand 12 asymptotisch der positiven Betriebsspannung $U_+$. Die Zeit, die vergeht, bis der erste Kurvenverlauf 30 die Spannung $U_C$ annimmt, die einer oberen Schaltschwelle $S_H$ des Komparators 14 entspricht, bei der Komparator 14 von Lowpegel (L-Pegel) auf H-Pegel umschaltet, wird als erste konstante Zeit $T_{KH}$ bezeichnet. Anhand des in Figur 3 gezeigten zweiten Kurvenverlaufs 31 wird eine untere Schaltschwelle $S_L$ des Komparators 14 gelernt. Ausgehend von einer Kondensatorspannung $U_C$, die der positiven Betriebsspannung $U_+$ entspricht, wird der Kondensator 10 über den Integrationswiderstand 12 entladen bis er asymptotisch die negative Betriebsspannung GND erreicht. Die Zeit, die vergeht, bis der Komparator 14 die untere Schaltschwelle $S_L$ erreicht, bei der der Komparator 14 von H-Pegel auf L-Pegel umschaltet, wird als zweite konstante Zeit $T_{KL}$ bezeichnet.

In Figur 4 ist ein erster Signalverlauf 32 gezeigt, bei dem die Kondensatorspannung $U_C$, ausgehend von einer ersten zu wandelnden Spannung $U_{x1}$, die obere Schaltschwelle $S_H$ des Komparators 14 erreicht. Die Zeit, innerhalb der die Kondensatorspannung $U_C$ bis zum Erreichen der oberen Schaltschwelle $S_H$ des Komparators 14 ansteigt, wird als erste Wandlungszeit $T_H$ bezeichnet.

Figur 5 zeigt einen zweiten Signalverlauf 33, bei dem die Kondensatorspannung $U_C$, ausgehend von einer zweiten zu umwandelnden Spannung $U_{x2}$, die untere Schaltschwelle $S_L$ des Komparators 14 erreicht. Die Zeit, innerhalb der die Kondensatorspannung $U_C$ die untere Schaltschwelle $S_L$ des Komparators 14 erreicht, wird als zweite Wandlungszeit

$T_L$ bezeichnet.

Das erfindungsgemäße Verfahren wird anhand des in Figur 1 gezeigten Blockschaltbilds in Verbindung mit dem in Figur 2 gezeigten Flußdiagramm sowie in Verbindung mit den in Figur 3 bis 5 gezeigten signalverläufen näher erläutert:

Sofern die wenigstens eine Schaltschwelle $S_H$, $S_L$ des Komparators 14 nicht bekannt ist, kann ein experimentelles Ermitteln der wenigstens einen Schaltschwelle $S_H$, $S_L$ erfolgen. Ein gegebenenfalls vorhandener Mikroprozessor 17, der vorzugsweise den Umschalter 13, den Komparator 14 sowie die Zeitermittlung 15 erhält, kann jederzeit zum Lernen der mindestens einen Schaltschwelle $S_H$, $S_L$ des Komparators 14 zweckmäßig eingesetzt werden. Für das erfindungsgemäße Verfahren hat der absolute Wert der Schaltschwelle $S_H$, $S_L$ keine Bedeutung. Wesentlich ist dagegen entweder die erste konstante Zeit $T_{KH}$ oder die zweite konstante Zeit $T_{KL}$. Die beiden konstanten Zeiten $T_{KH}$, $T_{KL}$ sind ein Maß für die Zeitkonstante des den Kondensator 10 sowie den Integrationswiderstand 12 enthaltenden RC-Glieds 10, 12. Der Integrationswiderstand 12 ist dabei als strombegrenzendes Element eingesetzt. Prinzipiell geeignet ist als solches strombegrenzendes Element beispielsweise auch eine Stromquelle.

Der Komparator 14 ist vorzugsweise eine Eingangsschaltung eines logischen Schaltkreises, die den wenigstens einen Schaltpegel $S_H$, $S_L$ aufweist. Eine solche Eingangsschaltung ist beispielsweise hinter Input Ports von Mikroprozessoren enthalten. Input Ports mit Schmitt-Trigger-Eingang weisen die beiden Schaltschwellen $S_H$, $S_L$ auf, die einer Hysterese entsprechen. Das Ausgangssignal $U_{COMP}$ des Komparators 14 entspricht dem internen logischen Signal des Input Ports.

Das Lernen der oberen Schaltschwelle $T_H$ erfolgt dadurch, daß der erste Kurvenverlauf 30, der in Figur 3 gezeigt ist, vorgegeben wird. Ausgehend vom spannungslosen Zustand des Kondensators 10, wird der erste Umschalter 13 auf die positive Betriebsspannung $U_+$ geschaltet. Die Kondensatorspannung $U_C$ steigt daraufhin vom Ausgangswert, der der negativen Betriebsspannung GND entspricht, gemäß dem ersten Kurvenverlauf 30 an. Beim Erreichen der oberen Schaltschwelle $S_H$ des Komparators 14 springt das Komparatorausgangssignal $U_{COMP}$ von einem L-Pegel auf einen H-Pegel. Vorausgesetzt ist hierbei, daß das Komparatorausgangssignal $U_{COMP}$ unterhalb der unteren Schaltschwelle $S_L$ L-Pegel aufweist und bei einer ansteigenden Kondensatorspannung erst auf H-Pegel schaltet bei Erreichen der oberen Schaltschwelle $S_H$. Die beiden Schaltschwellen $S_H$, $S_L$, die hier zugrunde gelegt sind, unterscheiden sich durch einen vorgebbaren Hysteresewert, der bei integrierten Logikschaltungen herstellerseitig festgelegt ist. Die Zeit zwischen dem Umschalten des Umschalters 13 auf die positive Betriebsspannung $U_+$ und dem Übergang des Komparatorausgangsignals $U_{COMP}$ von L-Pegel auf H-Pegel entspricht der ersten konstanten Zeit $T_{KH}$, die in einem in Figur 1 nicht gezeigten Speicher hinterlegt wird.

Es gilt:

$$S_H = U_+ * (1 - \exp(-T_{KH}/RC)) \qquad \text{(Gleichung 1)}$$

wobei R der Widerstand des Integrationswiderstands 11 und C der Kapazitätswert des Kondensators 10 ist.

In entsprechender Weise kann die untere Schaltschwelle $S_L$ des Komparators 14 anhand des zweiten Kurvenverlaufs 31 gelernt werden. Der zweite Kurvenverlauf 31 startet bei einer Kondensatorspannung $U_C$, die der positiven Betriebsspannung $U_+$ entspricht. Die Annäherung des zweiten Kurvenverlaufs 31 an die negative Betriebsspannung GND wird durch eine Abintegration durch den Integrationswiderstand 12 bewirkt, der mit dem Umschalter 13 auf die negative Betriebsspannung GND geschaltet wurde. Die Zeit zwischen dem Umschaltvorgang des Umschalters 13 auf die negative Betriebsspannung GND und den Bereichen der unteren Schaltschwelle $S_L$ des Komparators 14 entspricht der zweiten konstanten Zeit $T_{KL}$, die in einem in Figur 1 nicht gezeigten Speicher ebenfalls hinterlegt wird.

Es gilt:

$$S_L = U_+ * \exp(-T_{KL}/RC) \qquad \text{(Gleichung 2)}$$

Sofern lediglich eine Schaltschwelle des Komparators 14 vorgesehen ist, kann für das Lernen der Schaltschwelle entweder der erste Kurvenverlauf 30 oder der zweite Kurvenverlauf 31 zugrunde gelegt werden. Wesentlich ist lediglich das Erfassen des Übergangs von L-Pegel auf H-Pegel oder von H-Pegel auf L-Pegel des Komparatorausgangssignals $U_{COMP}$.

Eine Analog-/Digital-Wandlung beginnt mit dem in Figur 2 gezeigten Start 20, nachdem die wenigstens eine Schaltschwelle $S_H$, $S_L$ des Komparators 14 bekannt ist, wobei die wenigstens eine Schaltschwelle $S_H$, $S_L$ einer Vergleichsspannung entspricht. Im ersten Verfahrensschritt 21 wird die Kondensatorspannung $U_C$ auf die zu wandelnde Spannung $U_x$ gebracht. Die zu wandelnde Spannung $U_x$ gelangt über den Eingangswiderstand 11 (und Integrationswiderstand 12) auf den Kondensator 10. Der Eingangswiderstand 11 kann so groß gewählt werden, daß Schwankungen von der zu wandelnden Spannung $U_x$ während der Wandlung wenigstens näherungsweise keinen Einfluß auf die Wandlung haben. In einer anderen Ausgestaltung kann eine vollständige Trennung der zu wandelnden Spannung $U_x$ vom Kondensator 10 während der nachfolgenden Verfahrensschritte vorgesehen sein. In einem zweiten Verfahrensschritt wird der Kondensator 10 über das strombegrenzende Element 12, beispielsweise den Integrationswiderstand 12 mit einer Spannungsquelle verbunden, deren Spannung höher oder niedriger liegt als die der wenigstens einen Schaltschwelle $S_H$, $S_L$ entsprechenden Vergleichsspannung des Komparators 14. Der Integrationswiderstand 12 kann auch in der zum Umschalter 13 führenden Leitung angeordnet sein, so daß der Eingangswiderstand 11 unmittelbar am Kondensator 10 liegt. Im gezeigten Ausführungsbeispiel sind die vorgegebenen Spannungen einerseits die positive Betriebsspannung $U_+$ und andererseits die negative Betriebsspannung GND des Mikroprozessors 17.

Gegebenenfalls ist die Abfrage 22 vorgesehen, bei der der Umschalter 13 in Abhängigkeit vom Komparatorausgangssignal $U_{COMP}$ betätigt wird. Sofern das Komparatorausgangssignal H-Pegel aufweist, wird der Umschalter 13 auf die negative Betriebsspannung GND in der ersten Anweisung 23 geschaltet. Falls das Komparatorausgangssignal $U_{COMP}$ L-Pegel aufweist, wird in der zweiten Anweisung 24 der Umschalter 13 auf die positive Betriebsspannung $U_+$ geschaltet. Für die Pegelfestlegung gelten wieder die bereits oben beschriebenen Voraussetzungen. Prinzipiell ist es nicht erforderlich, den Umschalter 13 in Abhängigkeit vom Komparatorausgangssignal $U_{COMP}$ zu betätigen. Geeignet ist auch eine sequentielle zwangsläufige Hin- und Herschaltung zwischen beiden Spannungen, wobei im nachfolgenden zweiten Verfahrensschritt dann in jedem Fall eine Pegeländerung des Komparatorausgangssignals $U_{COMP}$ erhalten wird. Mit der gegebenenfalls vorgesehenen Steuerung des Umschalters 13 in Abhängigkeit vom Komparatorausgangssignals $U_{COMP}$ wird sichergestellt, daß im nachfolgenden zweiten Verfahrensschritt nach einem Schaltvorgang stets ein Pegelwechsel des Komparatorausgangssignals $U_{COMP}$ auftritt.

Ist die erste zu wandelnde Spannung $U_{x1}$ so klein, daß das Komparatorausgangssignal $U_{COMP}$ L-Pegel aufweist, so wird im zweiten Verfahrensschritt gemäß der zweiten Anweisung 24 der Umschalter mit der positiven Betriebsspannung $U_+$ verbunden. Ausgehend von der in Figur 2 gezeigten ersten wandelnden Spannung $U_{x1}$ steigt die Kondensatorspannung $U_C$ gemäß dem ersten Signalverlauf 32 an. Beim Erreichen der oberen Schaltschwelle $S_H$ des Komparators 14 wechselt das Komparatorausgangssignal $U_{COMP}$ von L-Pegel auf H-Pegel. Die Zeitermittlung 15 ermittelt die Zeit, die zwischen dem Schalten des Umschalters 13 auf die positive Betriebsspannung $U_+$ vergeht bis zum Erreichen der oberen Spannungsschwelle $S_H$, die gleich der ersten Wandlungszeit $T_H$ ist.

Es gilt:

$$S_H = U_{x1} + (U_+ - U_{x1}) * (1 - \exp(- T_{KH}/RC)) \qquad \text{(Gleichung 3)}$$

Durch Gleichsetzen von Gleichung 3 mit Gleichung 1 wird erhalten:

$$S_H = U_{x1} + (U_+ - U_{x1}) * (1 - \exp(-T_{KH}/RC))$$

$$= U_+ * (1 - \exp(-T_{KH}/RC))$$

darauf folgt für $U_{x1}$:

$$U_{x1} = U_+ * (1-\exp((T_H - T_{KH})/RC))$$

Daraus ergibt sich, daß die erste zu wandelnde Spannung $U_{x1}$ lediglich von der ersten Wandlungszeit $T_H$ abhängt. Die anderen vorkommenden Größen sind bekannt.

Ist die zu wandelnde Spannung $U_x$ so groß, daß das Komparatorausgangssignal $U_{COMP}$ H-Pegel aufweist, so wird in der ersten Anweisung 23 im zweiten Verfahrensschritt der Umschalter 13 auf die negative Betriebsspannung GND geschaltet. Der in Figur 5 gezeigte Signalverlauf 33 beginnt dementsprechend bei der zweiten zu wandelnden Spannung $U_{x2}$ und fällt anschließend auf niedrigere Spannungswerte ab. Beim Erreichen der unteren Schaltschwelle $S_L$ des Komparators 14 wechselt das Komparatorausgangssignal von H-Pegel auf L-Pegel. Die Zeitermittlung 15 erfaßt die zwischen dem Schalten des Umschalters 13 und dem Pegelwechsel vergangene Zeit als zweite Wandlungszeit $T_L$. Es gilt:

$$S_L = U_{x2} * \exp(-T_L/RC) \qquad \text{(Gleichung 4)}$$

Durch Gleichsetzen von Gleichung 2 mit Gleichung 4 erhält man:

$$S_L = U_{x2} * \exp(-T_L/RC) = U_+ * (- T_{KL}/RC)$$

darauf folgt für $U_{x2}$:

$$U_{x2} = U_+ * \exp((T_L - T_{KL})/RC)$$

Die zweite zu wandelnde Spannung $U_{x2}$ hängt demnach lediglich von der zweiten Wandlungszeit $T_L$ ab. Die anderen Größen sind bekannt.

Die Zeitermittlung 15, die als Ergebnissignal entweder die erste oder die zweite Wandlungszeit $T_H$, $T_L$ ermittelt, gibt diese Zeiten, die bereits ein Maß für das zu wandelnde elektrische Signal sind, als Ergebnissignal 18 vorzugsweise innerhalb des Mikroprozessors 17 weiter zu einer Berechnung, die die Zeiten $T_H$ oder $T_L$ beispielsweise in eine Spannungsangabe oder Stromangabe umrechnet. Die Ergebnisse der Exponentialfunktionen werden vorzugsweise mit Tabellen ermittelt, die in einem nicht näher gezeigten Speicher des Mikroprozessors 17 abgelegt sind.

## Patentansprüche

1. Verfahren zum Analog/Digital-Wandeln einer elektrischen Spannung mit den Merkmalen:

   - in einem ersten Schritt (21) wird ein Kondensator (10), der mit einem ersten Anschluß an ein festes Bezugspotential (GND) angeschlossen ist, auf die zu wandelnde Spannung ($U_{x1}$, $U_{x2}$) geladen, die unmittelbar an den zweiten Anschluß des Kondensators (10) gelegt wird;

   - in einem zweiten Schritt wird der Kondensator (10) umgeladen durch Verbinden seines zweiten Anschlusses über ein strombegrenzendes Element (12) mit einer Spannungsquelle ($U_+$, GND), wobei ein Komparator (14), der die Spannung am Kondensator (10) mit einer Vergleichsspannung ($S_H$, $S_L$) vergleicht, die Richtung der Umladung bestimmt durch Auswahl der Spannung der Spannungsquelle ($U_+$, GND);

   - in einem dritten Schritt wird die Zeit ($T_H$, $T_L$) einer Spannungsänderung am Kondensator (10) bis zum Erreichen der Vergleichsspannung ($S_H$, $S_L$) ermittelt und

   - die ermittelte Zeit ($T_H$, $T_L$) wird als Maß für die zu wandelnde Spannung ($U_{x1}$, $U_{x2}$) gewertet.

2. Verfahren nach Anspruch 1, dadurch gekennzeichnet, daß der Komparator (14) eine Hysterese aufweist, die eine obere Schaltschwelle ($S_H$) sowie eine untere Schaltschwelle ($S_L$) ergibt.

3. Verfahren nach Anspruch 1, dadurch gekennzeichnet, daß die wenigstens eine Schaltschwelle ($S_H$, $S_L$) des Komparators (14) in einem vorgeschalteten Verfahrensschritt gelernt wird.

4. Vorrichtung zum Analog/Digital-Wandeln einer elektrischen Spannung mit den Merkmalen:

   - die zu wandelnde Spannung ($U_{x1}$, $U_{x2}$) ist an einen zweiten Anschluß eines Kondensators (10) gelegt, dessen erster Anschluß an ein festes Bezugspotential (GND) angeschlossen ist;

   - der Kondensator (10) ist zum Umladen über einen Umschalter (13) und einen Integrationswiderstand (12) als strombegrenzendes Element mit einer Spannungsquelle ($U_+$, GND) verbindbar;

   - der Umschalter (13) ist von einem Komparator (14) geschaltet, der die Spannung am Kondensator (10) mit einer Vergleichsspannung ($S_H$, $S_L$) vergleicht, wobei die Richtung der Umladung bestimmt ist durch Auswahl der Spannung der Spannungsquelle ($U_+$, GND);

   - das Komparatorausgangssignal ($U_{COMP}$) ist einer Zeitermittlung (15) zugeleitet, welche die Zeit ($T_H$, $T_L$) einer Spannungsänderung am Kondensator (10) bis zum Erreichen der Vergleichsspannung ($S_H$, $S_L$) ermittelt, wobei die ermittelte Zeit ($T_H$, $T_L$) als Maß für die zu wandelnde Spannung ($U_{x1}$, $U_{x2}$) gewertet ist.

**5.** Vorrichtung nach Anspruch 4, dadurch gekennzeichnet, daß die zu wandelnde Spannung ($U_{x1}$, $U_{x2}$) über einen Eingangswiderstand (11) mit dem Kondensator (10) verbindbar ist.

**6.** Vorrichtung nach Anspruch 4, dadurch gekennzeichnet, daß der Umschalter (13) einen hochohmigen Schaltzustand aufweist.

**7.** Vorrichtung nach Anspruch 4, dadurch gekennzeichnet, daß die Spannung der Spannungsquelle ($U_+$, GND) der positiven oder der negativen Betriebsspannung entspricht.

**8.** Vorrichtung nach Anspruch 4, dadurch gekennzeichnet, daß der Umschalter (13), der Komparator (14) sowie die Zeitermittlung (15) in einem Mikroprozessor (17) enthalten sind.

**9.** Vorrichtung nach Anspruch 4 oder 8, dadurch gekennzeichnet, daß der Komparator (14) eine Eingangsschaltung eines logischen Schaltkreises ist.

**10.** Vorrichtung nach Anspruch 9, dadurch gekennzeichnet, daß die Eingangsschaltung in einem Input-Port eines Mikroprozessors (17) enthalten ist.

**Claims**

**1.** Method for the analogue/digital conversion of an electric voltage, having the features:

- in a first step (21), a capacitor (10), which is connected by a first terminal to a fixed reference-earth potential (GND), is charged to the voltage ($U_{x1}$, $U_{x2}$) which is to be converted and is applied directly to the second terminal of the capacitor (10);
- in a second step, the capacitor (10) is subjected to charge reversal by connecting its second terminal via a current-limiting element (12) to a voltage source ($U_+$, GND), a comparator (14), which compares the voltage across the capacitor (10) with a comparison voltage ($S_H$, $S_L$), determining the direction of the charge reversal by selection of the voltage of the voltage source ($U_+$, GND);
- in a third step, the time ($T_H$, $T_L$) taken by a voltage change at the capacitor (10) until the comparison voltage ($S_H$, $S_L$) is reached is determined, and
- the determined time ($T_H$, $T_L$) is rated as a measure of the voltage ($U_{x1}$, $U_{x2}$) to be converted.

**2.** Method according to Claim 1, characterized in that the comparator (14) has hysteresis which produces an upper switching threshold ($S_H$) and a lower switching threshold ($S_L$).

**3.** Method according to Claim 1, characterized in that the at least one switching threshold ($S_H$, $S_L$) of the comparator (14) is learned in a preceding method step.

**4.** Device for the analogue/digital conversion of an electric voltage, having the features:

- the voltage ($U_{x1}$, $U_{x2}$) to be converted is applied to a second terminal of a capacitor (10) whose first terminal is connected to a fixed reference-earth potential (GND);
- for the purpose of charge reversal, the capacitor (10) can be connected to a voltage source ($U_+$, GND) via a changeover switch (13) and an integration resistor (12) as current-limiting element;
- the changeover switch (13) is switched by a comparator (14), which compares the voltage across the capacitor (10) with a comparison voltage ($S_H$, $S_L$), the direction of the charge reversal being determined by selection of the voltage of the voltage source ($U_+$, GND);
- the comparator output signal ($U_{COMP}$) is forwarded to a time-determination arrangement (15), which determines the time ($T_H$, $T_L$) taken by a voltage change at the capacitor (10) until the comparison voltage ($S_H$, $S_L$) is reached, the determined time ($T_H$, $T_L$) being rated as a measure of the voltage ($U_{x1}$, $U_{x2}$) to be converted.

**5.** Device according to Claim 4, characterized in that the voltage ($U_{x1}$, $U_{x2}$) to be converted can be connected via an input resistor (11) to the capacitor (10).

**6.** Device according to Claim 4, characterized in that the changeover switch (13) has a high-impedance switch state.

7. Device according to Claim 4, characterized in that the voltage of the voltage source ($U_+$, GND) corresponds to the positive or negative operating voltage.

8. Device according to Claim 4, characterized in that the changeover switch (13), the comparator (14) and the time-determination arrangement (15) are contained in a microprocessor (17).

9. Device according to Claim 4 or 8, characterized in that the comparator (14) is an input circuit of a logic circuit.

10. Device according to Claim 9, characterized in that the input circuit is contained in an input port of a microprocessor (17).

**Revendications**

1. Procédé de conversion analogique/numérique d'une tension électrique,
   caractérisé en ce que

   - dans une première étape (21) on charge un condensateur (10) relié par une première borne à une tension de référence fixe (GND), à la tension à convertir ($U_{x1}$, $U_{x2}$), qui est directement appliquée à la seconde borne du condensateur (10) ;
   - dans une deuxième étape, on change la charge du convertisseur (10) en reliant sa seconde borne par un élément limiteur de courant (12) à une source de tension ($U_+$, GND), à un comparateur (14) qui compare la tension du condensateur (10) à une tension de comparaison ($S_H$, $S_L$), et définit le sens du changement de charge en sélectionnant la tension de la source de tension (U, GND) ;
   - dans une troisième étape, on détermine le temps ($T_H$, $T_L$) d'un changement de tension sur le condensateur (10) jusqu'à atteindre la tension de comparaison ($S_H$, $S_L$) et,
   - on exploite le temps obtenu ($T_H$, $T_L$) comme mesure de la tension à convertir ($U_{x1}$, $U_{x2}$).

2. Procédé selon la revendication 1,
   caractérisé en ce que
   le comparateur (14) a une hystérésis donnant un seuil de commutation supérieur ($S_H$) et un seuil de commutation inférieur ($S_L$).

3. Procédé selon la revendication 1,
   caractérisé en ce qu'
   au moins un seuil de tension ($S_H$, $S_L$) du comparateur (14) est appris par une étape de procédé antérieure.

4. Dispositif de conversion analogique/numérique d'une tension électrique,
   caractérisé en ce que

   - la tension à convertir ($U_{x1}$, $U_{x2}$) est appliquée à une seconde borne d'un condensateur (10) dont la première borne est reliée à un potentiel de référence fixe (GND),
   - le condensateur (10) est relié pour changer de charge par un commutateur (13) et une résistance d'intégration (12) comme élément limitant le courant à une source de tension ($U_+$, GND),
   - le commutateur (13) est commuté par un comparateur (14) qui compare la tension du condensateur (10) à une tension de comparaison ($S_H$, $S_L$), et on détermine le sens du changement de charge en sélectionnant la tension de la source de tension ($U_+$, GND),
   - on applique le signal de sortie du comparateur ($U_{COMP}$) à un moyen de détermination de temps (15) qui détermine le temps ($T_H$, $T_L$) d'une variation de tension sur le condensateur (10) jusqu'à ce qu'elle atteigne la tension de comparaison ($S_H$, $S_L$), et le temps obtenu ($T_H$, $T_L$) est exploité comme une mesure de la tension à convertir ($U_{x1}$, $U_{x2}$).

5. Dispositif selon la revendication 4,
   caractérisé en ce que
   la tension à convertir ($U_{x1}$, $U_{x2}$) peut être reliée au condensateur (10) par une résistance d'entrée (11).

6. Dispositif selon la revendication 4,
   caractérisé en ce que

le commutateur (13) présente un état de commutation fortement ohmique.

7. Dispositif selon la revendication 4,
   caractérisé en ce que
   la tension de la source de tension ($U_+$, GND) correspond à la tension de fonctionnement positive ou à la tension de fonctionnement négative.

8. Dispositif selon la revendication 4,
   caractérisé en ce que
   le commutateur (13), le comparateur (14) et le moyen de détermination de temps (15) font partie d'un microprocesseur (17).

9. Dispositif selon la revendication 4 ou 8,
   caractérisé en ce que
   le comparateur (14) est le circuit d'entrée d'un circuit logique.

10. Dispositif selon la revendication 9,
    caractérisé en ce que
    le circuit d'entrée fait partie d'un port d'entrée d'un microprocesseur (17).

# FIG.1

U+    GND

13    17

U+
GND

11    12    14

Ux    UC    UCOMP

10    15    16

# FIG.2

START — 20

UC = Ux — 21

UCOMP = H — 22

nein

ja    23    24

UC → GND    UC → U+

25    26

TL    TH

FIG.3

FIG.4

FIG.5